# EUROPEAN PATENT APPLICATION

(11) **EP 4 611 027 A1**
(43) Date of publication of application: **03.09.2025**
(21) Application number: 25160149.8
(22) Date of filing: 26.02.2025
(51) Int. Cl.: H01L 21/67, F16J 15/02, F16J 15/06, F16J 15/10

(54) **HIGH-PRESSURE SUBSTRATE PROCESSING APPARATUS**

(30) Priority: 28.02.2024 KR 20240028643
(71) Applicant: HPSP Co., Ltd., Hwaseong-si, Gyeonggi-do 18449 (KR)
(72) Inventor: Lim, Kunyoung, Hwaseong-si, Gyeonggi-do 18449 (KR); Yoon, Hyeseong, Hwaseong-si, Gyeonggi-do 18449 (KR); Min, Bin hong, Hwaseong-si, Gyeonggi-do 18449 (KR)
(74) Representative: von Bülow & Tamada

(57) **Abstract**

Provided is a high-pressure substrate processing apparatus including: an inner chamber accommodating a substrate to be processed and a reaction gas forming a first pressure higher than atmospheric pressure; an outer chamber including an outer housing accommodating the inner chamber, and an outer door defining a protective space for accommodating a protective gas forming a second pressure set in relation to the first pressure together with the outer housing and the inner chamber, one of the outer housing and the outer door having a mounting groove formed in its corresponding surface facing the other one of the outer housing and the outer door; and a sealing unit accommodated in the mounting groove and in contact with the other one to isolate the protective gas from external air, and a vent channel extending along an intersecting direction that intersects the corresponding surface to discharge the protective gas flowing into the mounting groove.

## Description

### BACKGROUND

### Field

The present disclosure relates to an apparatus for processing a substrate under high pressure.

### Description of the Related Art

In general, various processing may be performed on a semiconductor wafer during a manufacturing process of a semiconductor device. Examples of the processing may include oxidation, nitriding, deposition, ion implantation, and other similar processes. The examples may also include a hydrogen or deuterium heat treatment process to improve interface properties of the semiconductor device.

A process gas used for the processing may be supplied to a chamber, and the process gas may act on the semiconductor wafer. The chamber may be required to be sealed to prevent leakage of the process gas. In order to secure sealing, a sealing member may be installed between structures coupled to each other in the chamber.

The sealing member may fill a gap between the structures, thereby preventing the process gas from flowing out of the chamber or external air from flowing thereinto. However, a high-pressure gas inside the chamber may flow into an installation groove in which the sealing member is installed, and cause a pressure difference between the inside and outside of the installation groove when the chamber is opened. This pressure difference may exert a force on the sealing member, thus causing the sealing member to be lifted or detached from the installation groove. If the sealing member is out of its position, the chamber seal may be compromised.

The related art described above is technical information that the inventor possessed to derive embodiments of the present disclosure or acquired during its derivation process, and may not necessarily be considered to belong to the known art publicly disclosed prior to this application.

### SUMMARY

An object of the present disclosure is to provide a high-pressure substrate processing apparatus for preventing a component that maintains the chamber seal from being lifted by a gas pressure when the chamber is opened.

Another object of the present disclosure is to provide a high-pressure substrate processing apparatus which may maintain the chamber seal intact.

According to an embodiment of the present disclosure, a high-pressure substrate processing apparatus includes: an inner chamber accommodating a substrate to be processed and a reaction gas forming a first pressure higher than atmospheric pressure; an outer chamber including an outer housing accommodating the inner chamber, and an outer door defining a protective space for accommodating a protective gas forming a second pressure set in relation to the first pressure together with the outer housing and the inner chamber, one of the outer housing and the outer door having a mounting groove fomed in its corresponding surface facing the other one of the outer housing and the outer door; and a sealing unit including a first compressed part capable of being compressed against the other one, a second compressed part capable of being compressed against a bottom surface of the mounting groove, and a vent channel extending along an intersecting direction that intersects the corresponding surface to discharge the protective gas flowing into the mounting groove, wherein the vent channel is disposed only in an inner region of a compression line that connects the first compressed part to the second compressed part.

The compression line may be disposed along a movement direction of the outer door, in which the outer door is moved to open and close the outer housing.

Each of the mounting groove and the sealing unit may have a closed-loop shape, and the compression line may continuously extend along an extension direction of a closed loop to form a compression closed-loop surface.

The vent channel may communicate the mounting groove with the protective space when the protective space is in a closed state.

The apparatus may further include a gas exhaust module communicating with the protective space and configured to exhaust the protective gas, wherein the protective gas flowing into the mounting groove is discharged to the protective space by the operation of the gas exhaust module.

A bottom of the vent channel may be spaced apart from an inner wall surface of the mounting groove when the protective space is in a closed state.

The sealing unit may include a body having a closed-loop shape, and the vent channel may include a groove formed in an inner circumferential surface of the body.

The plurality of grooves may be arranged at equal intervals along a circumferential direction of the body.

The mounting groove may have a semi-dovetail shape, and the vent channel may face an inclined inner wall surface of the mounting groove.

The outer door may be moved relative to the outer housing along a height direction to open and close the protective space, and the intersecting direction may be the same direction as the height direction.

According to another embodiment of the present disclosure, a high-pressure substrate processing apparatus includes: a first casing; a second casing including a mounting groove formed in its corresponding surface facing the first casing, and defining a process space for accommodating a substrate to be processed and a process gas forming a pressure higher than atmospheric pressure together with the first casing; and a sealing unit including a first compressed part capable of being compressed against the first casing, a second compressed part capable of being compressed against a bottom surface of the mounting groove, and a vent channel extending along a direction that intersects the corresponding surface to discharge the process gas flowing into the mounting groove, wherein the vent channel is disposed only in an inner region of a compression line that connects the first compressed part to the second compressed part.

The compression line may be disposed along a close contact direction in which the second casing is in close contact with the first casing.

Each of the mounting groove and the sealing unit may have a closed-loop shape, and the compression line continuously may extend along an extension direction of a closed loop to form a compression closed-loop surface.

The vent channel may communicate the mounting groove with the process space when the process space is in a closed state.

The sealing unit may include a body having a closed-loop shape, and the vent channel may include a groove formed in an inner circumferential surface of the body.

### BRIEF DESCRIPTION OF THE DRAWINGS

FIG. 1 is a conceptual diagram of a high-pressure substrate processing apparatus according to an embodiment of the present disclosure.
FIG. 2 is a partial cross-sectional view showing an opened state of an outer chamber in FIG. 1.
FIG. 3 is a perspective view showing a sealing unit in FIG. 2.
FIG. 4 is a partial cross-sectional view showing a closed state of the outer chamber in FIG. 2.

### DETAILED DESCRIPTION

Hereinafter, the present disclosure is described in detail with reference to the accompanying drawings.

The present disclosure is not limited to embodiments described below, may be variously modified, and may be implemented in various different forms. The embodiments are provided only to make the present disclosure complete and allow those skilled in the art to completely appreciate the scope of the present disclosure. Therefore, it should be understood that the present disclosure is not limited to the embodiments disclosed below, includes substitution or addition of a configuration in one embodiment with or to a configuration in another embodiment, as well as all modifications, equivalents, or substitutions, included in the spirit and scope of the present disclosure.

Furthermore, it should be understood that the accompanying drawings are provided only to allow the embodiments of the present disclosure to be easily understood, and the spirit of the present disclosure is not limited by the accompanying drawings, and includes all the modifications, equivalents and substitutions, included in the spirit and scope of the present disclosure. In consideration of convenience of understanding or the like, the size or thickness of a component may be expressed exaggeratedly large or small in the drawings, and the scope of the present disclosure should not be interpreted as being limited due to this expression.

Terms used in the specification are used only to describe specific implementation examples or embodiments rather than limiting the present disclosure. In addition, a term of a single number may include its plural number unless explicitly indicated otherwise in the context. Terms "include" or "have", and the like used in the specification specify the presence of features, numerals, steps, operations, components, parts, or combinations thereof, mentioned in the specification. That is, it should be understood that the terms "include" or "have", and the like do not preclude the presence or addition of one or more other features, numerals, operations, components, parts, or combinations thereof, which is mentioned in the specification.

Terms including ordinal numbers such as "first", "second", and the like, may be used to describe various components. However, these components are not limited by these terms. Such a term is used only to distinguish one component from another component.

It should be understood that when one element is referred to as being "connected/communicated to" or "in contact with" another element, one element may be directly connected/communicated to or in direct contact with another element, or may be connected/communicated to or in contact with another element while having a third element interposed therebetween. On the other hand, it should be understood that when one component is referred to as being "directly connected/communicated to" or "in direct contact with" another component, one component may be connected/communicated to or in contact with another component while having no third component interposed therebetween.

It should be understood that when an element is referred to as being "on" or "below" another element, the element may be "directly on" another element, or may have a third element interposed therebetween.

Unless defined otherwise, it should be understood that all the terms including technical and scientific terms, used herein, have the same meanings as those that are generally understood by those skilled in the art to which the present disclosure pertains. Terms generally used and defined by a dictionary should be interpreted as having the same meanings as meanings within a context of the related art, and should not be interpreted as having ideal or excessively formal meanings unless being clearly defined otherwise in this application.

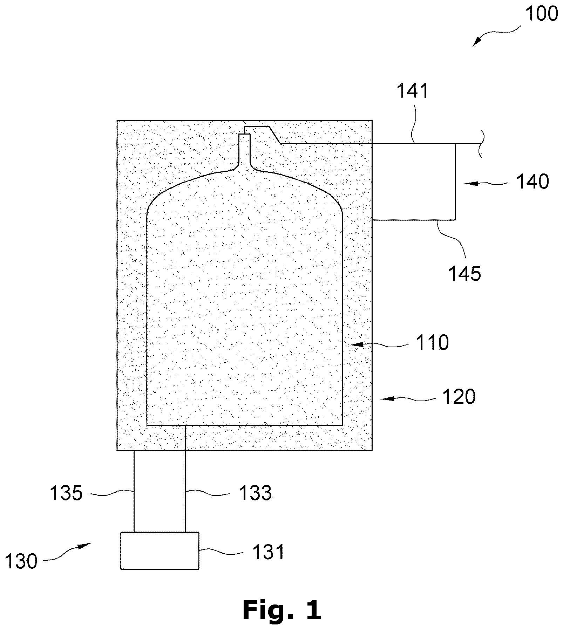

FIG. 1 is a conceptual diagram of a high-pressure substrate processing apparatus according to an embodiment of the present disclosure.

Referring to this drawing, a high-pressure substrate processing apparatus 100 may include an inner chamber 110, an outer chamber 120, a gas supply module 130, and a gas exhaust module 140.

The inner chamber 110 may include a processing area for processing a substrate to be processed. The inner chamber 110 may be made of a non-metallic material, such as quartz, to reduce a risk of substrate contamination in a high temperature and high pressure working environment. As a heater unit (not shown) disposed outside the inner chamber 110 is operated, a temperature in the processing area (processing temperature) may reach hundreds to thousands of degrees Celsius. The substrate may be, for example, a semiconductor wafer mounted on a holder. The substrate is not limited to the above wafer, and may also be another basic structure for fabricating a circuit. For example, the substrate may also include glass for producing a display. The holder may be a boat capable of supporting one or more substrates.

The outer chamber 120 may accommodate the inner chamber 110. Unlike the inner chamber 110, the outer chamber 120 may be free from the risk of substrate contamination, and thus be made of metal. The outer chamber 120 may be hollow to have an inner space for accommodating the inner chamber 110.

The gas supply module 130 is a component for supplying a gas to the inner chamber 110 and the outer chamber 120. The gas supply module 130 may include a gas supply device 131 communicating with a utility (or gas supply facility) of a semiconductor factory. The gas supply device 131 may selectively provide the inner chamber 110 with a reaction gas such as hydrogen gas (H₂), deuterium gas (D₂), fluorine gas (F₂), ammonia gas (NH₃), chlorine gas (Cl₂), or nitrogen gas (N₂). The gas supply device 131 may provide the outer chamber 120 with, for example, nitrogen, which is an inert gas, as a protective gas. Each of the reaction gas and the protective gas may be introduced into the inner chamber 110 or the outer chamber 120 through a reaction gas line 133 or a protective gas line 135. The protective gas introduced into the outer chamber 120 may be supplied to a space (protective space) between the outer chamber 120 and the inner chamber 110. The reaction gas and the protective gas may also be simply referred to as a process gas.

The process gas may be supplied to the chambers 110 and 120 to form a pressure higher than atmospheric pressure (i.e., high pressure), for example, from several atmospheres to several tens of atmospheres. A first pressure and a second pressure may be maintained to have a predetermined relationship (range) when the first pressure refers to the pressure in the inner chamber 110 that is formed by the reaction gas supply and the second pressure refers to the pressure in the outer chamber 120 that is formed by the protective gas supply. For example, the second pressure may be set to be substantially equal to or slightly greater than the first pressure. Such a pressure relationship may prevent leakage of the reaction gas from the inner chamber 110 and breakage of the inner chamber 110. The second pressure may be set to be slightly lower than the first pressure, and a similar effect as in the relationship described above may be achieved even in that case.

The gas exhaust module 140 is a component for exhausting the process gas. A gas exhaust line 141 may be connected to the top of the inner chamber 110 to exhaust the reaction gas from the inner chamber 110. Similarly, a gas exhaust pipe 145 connected to the outer chamber 120 may be provided to exhaust the protective gas from the outer chamber 120. When these gas exhaust lines 141 and 145 are integrated with each other, the reaction gas may be diluted with the protective gas during the exhaust process, thereby lowering its concentration.

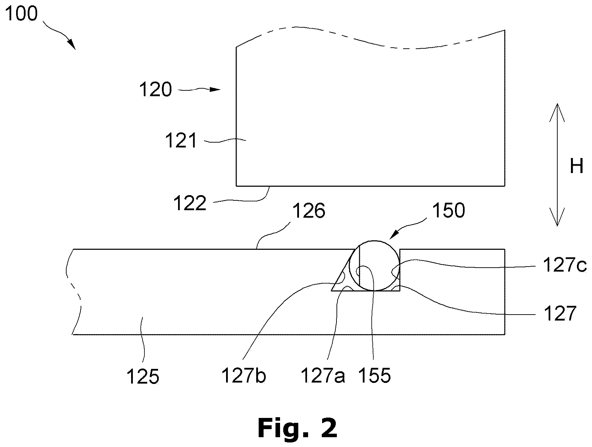

FIG. 2 is a partial cross-sectional view showing an opened state of the outer chamber in FIG. 1.

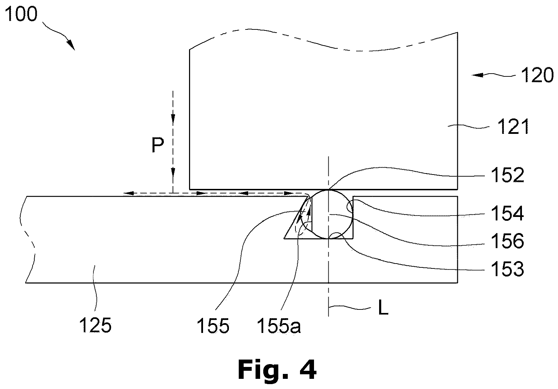

Referring to this drawing, the outer chamber 120 may include an outer housing 121 and an outer door 125. The outer housing 121 has a hollow space, and the bottom of the hollow space may be open. The outer door 125 may close the open bottom of the outer housing 121. The outer door 125 may define the protective space together with the outer housing 121 and the inner chamber 110. The protective space may be opened (or may enter its opened state; see FIG. 2) as the outer door 125 is lowered in its movement direction, specifically in a height direction H. The movement direction is the direction in which the outer door 125 approaches or moves away from the outer housing 121. As the outer door 125 is raised along the height direction H, the outer door 125 may be connected to the outer housing 121 via a sealing unit 150 described below. In this case, the protective space may be considered to be closed (or may enter its closed state; see FIG. 4). The height direction H is illustrated as a vertical direction in the drawing, is not necessarily limited to the vertical direction, and may be a direction slightly inclined relative to a vertical line in some cases.

For reference, to further describe the inner chamber 110, the inner chamber 110 may also include an inner housing (not shown) and an inner door (not shown). The inner housing and the inner door may be entirely surrounded by the outer housing 121 and the outer door 125. The inner housing may be mounted in the outer housing 121. The inner door may open and close the processing area while being moved in conjunction with the outer door 125. Accordingly, the opened state and the closed state (or closing state) may be implemented substantially the same for the inner chamber 110 as well as the outer chamber 120. The substrate may be loaded onto the holder or unloaded from the holder in the opened state.

With respect to the outer chamber 120 again, the sealing unit 150 may be disposed between the outer housing 121 and the outer door 125. The sealing unit 150 is intended to isolate the protective gas within the protective space from external air. Although the protective space is ultimately closed by the sealing unit 150, it may also be described that the protective space is generally defined by the outer housing 121 and the outer door 125.

For the installation of the sealing unit 150, the outer housing 121 and the outer door 125 may have their corresponding surfaces 122 and 126 facing each other. If one corresponding surface 122 is a lower surface of the outer housing 121, the other corresponding surface 126 may be an upper surface of the outer door 125. The corresponding surfaces 122 and 126 may be substantially parallel to each other. The corresponding surface 122 of the outer housing 121 may have, for example, a closed-loop shape.

The sealing unit 150 may also have a closed-loop shape corresponding to the shape of the corresponding surface 122. In detail, the sealing unit 150 may be an O-ring having a circular shape. The O-ring may contain silicone or the like to have a cushioning property and may have a sealing property to prevent the gas leakage therethrough. The O-ring may be accommodated in a mounting groove 127 formed in the corresponding surface 126 of the outer door 125. The O-ring may also be installed in the outer housing 121 if the mounting groove is disposed in the corresponding surface 122.

The mounting groove 127 may also have a closed-loop shape to corresponding to that of the sealing unit 150. A cross-section of the mounting groove 127 may be illustrated as having a semi-dovetail shape in this embodiment. Due to this shape, the mounting groove 127 may have an inner wall surface 127b inclined relative to a bottom surface 127a. The inner wall surface 127b may be a wall surface close to the center of the outer door 125. In an alternative embodiment, the mounting groove 127 may have a different shape, for example a dovetail shape or a rectangular shape.

A portion of the sealing unit 150 may be accommodated in the mounting groove 127, and the rest may protrude beyond the corresponding surface 126 along the height direction H. The bottom of the sealing unit 150 may be in contact with the bottom surface 127a of the mounting groove 127, and an inner circumferential surface of the sealing unit 150 may be in contact with the inclined inner wall surface 127b. An outer circumferential surface of the sealing unit 150 may also be in contact with an outer wall surface 127c of the mounting groove 127.

A vent channel 155 may be formed in the inner circumferential surface of the sealing unit 150. The vent channel 155 may face the inner wall surface 127b. The vent channel 155 may extend along an intersecting direction that intersects the corresponding surface 126. The intersecting direction may be substantially the same direction as the height direction H. The intersecting direction is not limited to a direction along a straight line, but may also be a direction along a curve.

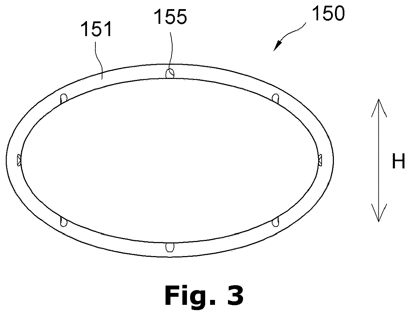

FIG. 3 is a perspective view showing the sealing unit in FIG. 2.

Referring to this drawing, the sealing unit 150 may include a body 151 including the vent channel 155 described above. The body 151 may have a closed-loop shape, specifically a circular shape. The body 151 may be made of a material having the sealing property and the cushioning property, such as silicone.

The vent channel 155 may be formed in the inner circumferential surface of the body 151. In detail, the vent channel 155 may be a groove extending generally along the height direction H. The plurality of grooves may be provided. In that case, the plurality of grooves may be arranged at equal intervals along a circumferential direction of the body 151.

The groove may have a substantially semicircular cross-section, and is not limited thereto. In an alternative embodiment, the groove may have a polygonal cross-section, such as a triangular cross-section, a rectangular cross-section, or a circular cross-section. If the groove has the circular cross-section, the vent channel 155 is required to penetrate through the body 151.

FIG. 4 is a partial cross-sectional view showing the closed state of the outer chamber in FIG. 2.

Referring to this drawing (and FIG. 2), as the outer door 125 is raised along the height direction H, the sealing unit 150 may come into contact with the outer housing 121. In more detail, the sealing unit 150 may be pressed along the height direction H. The top of the sealing unit 150 may be a first compressed part 152 capable of being compressed against the corresponding surface 122, and the bottom of the sealing unit 150 may be a second compressed part 153 capable of being compressed against the bottom surface 127a. A compression line L connecting the first compressed part 152, second compressed part 153, and central part 156 of the body 151 to one another may be formed as these parts 152, 153, and 156 are compressed. As the compression line L is aligned so that the outer door 125 is substantially aligned with the movement direction (or height direction H) of the outer housing 121, the sealing unit 150 may be strongly compressed to firmly maintain the outer chamber 120 in a sealed state even under the high pressure. The compression line L is a concept defined based on a cross-section of the sealing unit 150, and may also be defined as a compression closed-loop surface by considering an overall shape of the sealing unit 150. The compression closed-loop surface is a closed surface formed by continuously extending the compression line along an extension direction of a closed loop. Here, the closed loop is a loop formed by the mounting groove 127 (and the sealing unit 150). The outer circumferential surface of the sealing unit 150 may be a third compressed part 154 capable of being compressed against the outer wall surface 127c. The corresponding surfaces 122 and 126 may be slightly spaced from each other, and the protective gas may thus flow between these surfaces 122 and 126.

As the sealing unit 150 is compressed, the outer chamber 120 may enter the closed state. The protective space may also reach the closed state. In the closed state, the vent channel 155 may be disposed inside the compression line L that connects the first compressed part 152 to the second compressed part 153 (that is, in a space defined by the body 151 (see FIG. 3)) relative to the compression line L. The vent channel 155 may communicate the mounting groove 127 with the protective space. In the closed state, the protective gas may be supplied to the protective space to form the high pressure. The protective gas may flow into the mounting groove 127 through a passage P between the corresponding surfaces 122 and 126 (and the vent channel 155). The protective gas may be mainly confined in a space defined by the bottom surface 127a, the inner wall surface 127b, and the sealing unit 150. The protective gas flowing into the mounting groove 127 may not advance to the outside beyond the compression line L. The third compressed part 154 may be an additional line of defense to prevent the protective gas from advancing to the outside.

After a processing process is completed, the protective gas may be exhausted to the outside of the protective space through the gas exhaust module 140 (see FIG. 1). During this exhaust process, the protective gas flowing into the mounting groove 127 may be discharged to the protective space communicating with the mounting groove 127 by the vent channel 155. To this end, a bottom 155a of the vent channel 155 may be spaced apart from the inner wall surface 127b, thereby preventing the vent channel 155 from being blocked even in the closed state.

The sealing unit 150 may be prevented from being lifted the mounting groove 127 when the outer door 125 is separated from the outer housing 121 after the protective gas is completely exhausted. The reason is that the protective gas flowing into the mounting groove 127 does not remain in the mounting groove 127, thus causing no force to push up the sealing unit 150.

In the embodiment hereinabove, the sealing unit 150 is applied between the outer housing 121 and the outer door 125, and the present disclosure is not limited thereto. In an alternative embodiment, the sealing unit may also be applied as it is between the inner housing and the inner door. In that case, the inner housing may accommodate the substrate together with the inner door, and the sealing unit may seal the processing area accommodating the substrate relative to the protective space. The inner housing may be referred to as a first casing, and the inner door may be referred to as a second casing.

In the embodiment hereinabove, a processing apparatus having the dual chambers 110 and 120 is described as the high-pressure substrate processing apparatus 100, and the present disclosure is not limited thereto.

In an alternative embodiment, the sealing unit may also be applied to a substrate processing apparatus including a single chamber. In the single chamber, a plurality of structures may be coupled to each other to accommodate the substrate. The process gas for processing the substrate, for example, the reaction gas, may be supplied to a space where the substrate is accommodated to form the high pressure. The two structures that meet each other among the plurality of structures may be referred to as the first casing and the second casing in that these structures define a process space where a process for the substrate is performed. The sealing unit may be disposed between the first casing and the second casing. The mounting groove may be formed in the first casing or the second casing.

In another alternative embodiment, the sealing unit may be applied as it is to a semi-dual chamber as well. The semi-dual chamber may include two housings (i.e., inner housing and outer housing) and a single door. The two housings may be coupled to each other to form a closed space (corresponding to the protective space). The substrate may be disposed in and the reaction gas may be injected into a space defined by the inner housing and the door, and the protective gas may be injected into the closed space. The door may not be fully protected by the protective gas and may be exposed to the outside. In that respect, the door may correspond to the outer door in the double chamber. The sealing unit may be disposed between the door and the inner housing (or the outer housing).

Concepts of the first and second casings may be applied not only to the single chamber but also to the outer chamber 120 among the chambers 110 and 120. Focusing on the outer chamber 120 where the sealing unit is installed, the outer housing 121 may be identified as the first casing and the outer door 125 may be identified as the second casing. The concepts of the first and second casings may be equally applied to the semi-dual chamber. In that case, the inner or outer housing may be identified as the first casing, and the door may be identified as the second casing. This specification illustrates a batch-type processing apparatus, and the present disclosure is not limited thereto. The present disclosure may also be applied as it is to a single-wafer-type processing apparatus.

According to the high-pressure substrate processing apparatus according to the present disclosure configured as set forth above, the sealing unit disposed between the outer housing and outer door of the outer chamber accommodating the inner chamber may include the vent channel extending along an intersecting direction that intersects the corresponding surface to discharge the protective gas flowing into the mounting groove, thus enabling the sealing unit to be free from being lifted by the high-pressure protective gas remaining in the mounting groove when the outer chamber is opened. Even when the outer chamber is opened or closed and the pressure of the protective gas changes, the sealing unit may stably maintain its mounting state in the mounting groove, thereby maintaining the outer chamber seal intact.

## Claims

1. A high-pressure substrate processing apparatus comprising:
an inner chamber accommodating a substrate to be processed and a reaction gas forming a first pressure higher than atmospheric pressure;
an outer chamber including an outer housing accommodating the inner chamber, and an outer door defining a protective space for accommodating a protective gas forming a second pressure set in relation to the first pressure together with the outer housing and the inner chamber, one of the outer housing and the outer door having a mounting groove formed in its corresponding surface facing the other one of the outer housing and the outer door; and
a sealing unit including a first compressed part capable of being compressed against the other one, a second compressed part capable of being compressed against a bottom surface of the mounting groove, and a vent channel extending along an intersecting direction that intersects the corresponding surface to discharge the protective gas flowing into the mounting groove,
wherein the vent channel is disposed only in an inner region of a compression line that connects the first compressed part to the second compressed part.

2. The apparatus as claimed in claim 1, wherein the compression line is disposed along a movement direction of the outer door, in which the outer door is moved to open and close the outer housing.

3. The apparatus as claimed in claim 1, wherein each of the mounting groove and the sealing unit has a closed-loop shape, and
the compression line continuously extends along an extension direction of a closed loop to form a compression closed-loop surface.

4. The apparatus as claimed in claim 1, wherein the vent channel communicates the mounting groove with the protective space when the protective space is in a closed state.

5. The apparatus as claimed in claim 4, further comprising a gas exhaust module communicating with the protective space and configured to exhaust the protective gas,
wherein the protective gas flowing into the mounting groove is discharged to the protective space by the operation of the gas exhaust module.

6. The apparatus as claimed in claim 4, wherein a bottom of the vent channel is spaced apart from an inner wall surface of the mounting groove when the protective space is in a closed state.

7. The apparatus as claimed in claim 1, wherein the sealing unit includes a body having a closed-loop shape, and
the vent channel includes a groove formed in an inner circumferential surface of the body.

8. The apparatus as claimed in claim 7, wherein the plurality of grooves are provided and arranged at equal intervals along a circumferential direction of the body.

9. The apparatus as claimed in claim 1, wherein the mounting groove has a semi-dovetail shape, and
the vent channel faces an inclined inner wall surface of the mounting groove.

10. The apparatus as claimed in claim 1, wherein the outer door is moved relative to the outer housing along a height direction to open and close the protective space, and
the intersecting direction is the same direction as the height direction.

11. A high-pressure substrate processing apparatus comprising:
a first casing;
a second casing including a mounting groove formed in its corresponding surface facing the first casing, and defining a process space for accommodating a substrate to be processed and a process gas forming a pressure higher than atmospheric pressure together with the first casing; and
a sealing unit including a first compressed part capable of being compressed against the first casing, a second compressed part capable of being compressed against a bottom surface of the mounting groove,
and a vent channel extending along a direction that intersects the corresponding surface to discharge the process gas flowing into the mounting groove,
wherein the vent channel is disposed only in an inner region of a compression line that connects the first compressed part to the second compressed part.

12. The apparatus as claimed in claim 11, wherein the compression line is disposed along a close contact direction in which the second casing is in close contact with the first casing.

13. The apparatus as claimed in claim 11, wherein each of the mounting groove and the sealing unit has a closed-loop shape, and
the compression line continuously extends along an extension direction of a closed loop to form a compression closed-loop surface.

14. The apparatus as claimed in claim 11, wherein the vent channel communicates the mounting groove with the process space when the process space is in a closed state.

15. The apparatus as claimed in claim 11, wherein the sealing unit includes a body having a closed-loop shape, and
the vent channel includes a groove formed in an inner circumferential surface of the body.
